# FASCICULE DE BREVET EUROPEEN

(11) **EP 2 533 244 B1**
(45) Date de publication et mention de la délivrance du brevet: **25.03.2015**
(21) Numéro de dépôt: 12170677.4
(22) Date de dépôt: 04.06.2012
(51) Int. Cl.: G11C 11/16

(54) **Dispositif magnétique à couplage d'echange**
Magnetvorrichtung mit Wechselschaltung
Magnetic device with exchange coupling

(30) Priorité: 06.06.2011 FR 1154899
(43) Date de publication de la demande: 12.12.2012
(73) Titulaire: COMMISSARIAT A L'ENERGIE ATOMIQUE ET AUX ENERGIES ALTERNATIVES, 75015 Paris (FR)
(72) Inventeur: Moritz, Jérôme, 38870 Saint Pierre De Bressieux (FR); Dieny, Bernard, 38250 Lans en Vercors (FR)
(74) Mandataire: Lebkiri, Alexandre

(56) Documents cités:
- US-A1- 2010 090 300

## Description

La présente invention se rattache au domaine des matériaux magnétiques et concerne plus particulièrement un dispositif magnétique à couplage d'échange (« Exchange Bias » selon la terminologie anglaise) entre un matériau ferromagnétique et un matériau antiferromagnétique. Le dispositif selon l'invention est notamment destiné à être mis en oeuvre dans des mémoires magnétiques à écriture assistée thermiquement, dans des capteurs de champ magnétique ou des têtes de lecture pour support d'enregistrement magnétique, etc...

L'invention trouve une application particulièrement intéressante dans la réalisation de points mémoire et de mémoire de type MRAM (« Magnetic Random Access Memory » ou mémoire magnétique à accès direct) à écriture assistée thermiquement.

Les mémoires magnétiques MRAM ont connu un regain d'intérêt avec la mise au point de jonction tunnel magnétique présentant une forte magnétorésistance à température ambiante. Les mémoires MRAM comportent plusieurs points mémoires. Ces points mémoires sont généralement des dispositifs magnétiques qui comportent :
- une couche magnétique appelée « couche de référence » qui présente une aimantation dont la direction est fixe ;
- une couche magnétique appelée « couche de stockage » qui présente une aimantation dont la direction est variable et qui peut s'orienter soit parallèlement, soit antiparallèlement à la direction d'aimantation de la couche de référence ;
- un espaceur réalisé dans un matériau isolant ou semi-conducteur qui sépare la couche de référence et la couche de stockage.

Le document FR2817999 décrit par exemple un tel dispositif magnétique. Ce dispositif magnétique présente deux modes de fonctionnement : un mode « lecture » et un mode « écriture ». Lors du mode écriture, un courant d'électrons ou un champ magnétique est envoyé à travers les couches, de façon à provoquer le retournement de la direction d'aimantation de la couche de stockage, qui devient alors parallèle ou antiparallèle à la direction d'aimantation de la couche de référence. Suivant que la direction d'aimantation de la couche de stockage est parallèle ou antiparallèle à la direction d'aimantation de la couche de référence, un « 1 » ou un « 0 » est stocké dans la couche de stockage.

Lors du mode lecture, un courant d'électrons est injecté à travers le dispositif magnétique de façon à lire sa résistance. Lorsque les directions d'aimantation de la couche de référence et de la couche de stockage sont parallèles, la résistance de la jonction est faible, tandis que lorsque les directions d'aimantation des couches de référence et de stockage sont antiparallèles, la résistance de la jonction est élevée. Par comparaison avec une résistance de référence, la valeur stockée dans la couche de stockage (« 0 » ou « 1 ») peut être déterminée.

Le document FR2924851 propose par ailleurs d'ajouter au dispositif décrit précédemment une couche antiferromagnétique au contact de la couche de stockage. En mode lecture, cette couche antiferromagnétique permet de figer la direction d'aimantation de la couche de stockage afin que l'information stockée dans la couche de stockage ne varie pas. En mode écriture par contre, la couche antiferromagnétique est chauffée de façon à ce qu'elle devienne paramagnétique ou tout au moins que sa température excède la température dite de blocage de la couche antiferromagnétique. Ce phénomène, appelé anisotropie d'échange (ou « exchange bias » en anglais), est basé sur le principe suivant : lorsqu'un matériau ferromagnétique est mis en contact avec un matériau antiferromagnétique, il peut y avoir apparition d'anisotropie unidirectionnelle : le cycle d'hystérésis du matériau ferromagnétique présente alors un décalage en champ comme si un champ constant venait se superposer au champ extérieur appliqué ; ce champ constant résulte de l'interaction d'échange à travers l'interface avec le matériau antiferromagnétique

La température de blocage est en générale inférieure à la température de Néel du matériau antiferromagnétique mais elle se rapproche de plus en plus de la température de Néel au fur et à mesure que la durée du chauffage diminue vers des durées de l'ordre de quelques nanosecondes. La température de Néel du matériau antiferromagnétique est la température à laquelle l'ordre antiferromagnétique disparait et au dessus de laquelle le matériau se comporte comme un paramagnétique. Lorsque la température de la couche antiferromagnétique dépasse la température de blocage, la direction d'aimantation de la couche de stockage peut alors être modifiée puisqu'elle n'est plus piégée par la couche antiferromagnétique. Une fois que l'on a modifié la direction d'aimantation de la couche de stockage, le chauffage de la couche antiferromagnétique est arrêté. La couche antiferromagnétique redevient alors antiferromagnétique. La direction d'aimantation de la couche de stockage est alors piégée dans la direction dans laquelle elle se trouvait à l'issue du processus d'écriture. Les dispositifs magnétiques qui comportent une telle couche antiferromagnétique et mettent en oeuvre un chauffage temporaire de cette couche au moment de l'écriture de l'information font partie des dispositifs dits « à écriture assistée thermiquement ».

Les dispositifs magnétiques à écriture assistée thermiquement sont avantageux car ils permettent de diminuer le risque d'écriture accidentelle lors de la lecture de l'information contenue dans la couche de stockage. Par ailleurs, ils possèdent une bien meilleure rétention que les dispositifs ne mettant pas en oeuvre l'assistance thermique, c'est-à-dire qu'ils ont une meilleure capacité à conserver l'information écrite au cours du temps.

Toutefois, dans ces dispositifs à écriture assistée thermiquement, on observe une densité importante de défauts structurels en raison de l'incompatibilité structurelle entre la couche antiferromagnétique, qui présente généralement une structure cristallographique cubique face centrée, et la couche de stockage, qui présente généralement une structure cristallographique cubique centrée lorsqu'elle est en contact avec une barrière tunnel de MgO. Ces défauts structurels ont un impact direct sur la qualité du piégeage de la couche de stockage par la couche antiferromagnétique.

Pour remédier à ces inconvénients, le document FR2924851 propose d'ajouter dans la couche de stockage une couche amorphe ou quasi-amorphe, par exemple en Tantale, ainsi qu'une couche ferromagnétique à structure cristallographique cubique face centrée, par exemple en permalloy NiFe. L'ajout de ces couches permet de réaliser une transition structurelle entre la couche antiferromagnétique et les couches qui présentent une structure cristallographique cubique centré.

Toutefois, les dispositifs magnétiques à écriture assistée thermiquement de l'art antérieur présentent de nombreux inconvénients lorsque l'on diminue l'épaisseur de la couche antiferromagnétique ou la taille latérale de ces dispositifs.

Ainsi, comme mentionné plus haut, les couches antiferromagnétiques utilisées dans les dispositifs à écriture assistés thermiquement pour piéger les couches de stockages cristallisent dans le réseau cubique à faces centrées (cas des composés FeMn et IrMn). La croissance de ces matériaux se fait généralement selon l'axe [111] des plans denses, axe de croissance d'autant plus marqué que les couches tampons suivent le même axe, ce qui est le cas de NiFe, par exemple, et plus généralement des alliages à base de Co réalisés par pulvérisation cathodique. Dans les plans (111), les moments magnétiques composant le réseau antiferromagnétique sont orientés de manière à ce que le moment résultant total soit nul : on appelle ces composés des matériaux antiferromagnétiques à moments compensés (voir J. Phys. Soc. Jpn 21, 1281 (1966) et J. Appl. Phys. 75, 6659 (1994) pour le composé FeMn et J. Appl. Phys. 86, 3853 (1999) pour IrMn).

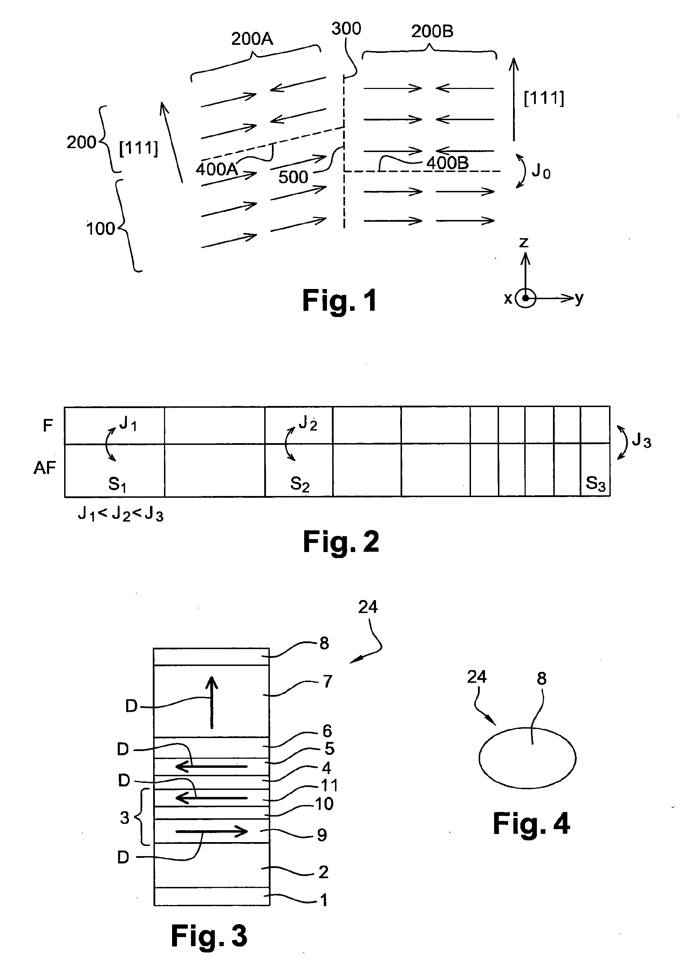

Cet ensemble de moments non compensés devrait théoriquement entraîner une absence de couplage d'échange entre la couche ferromagnétique et la couche antiferromagnétique mais il existe dans les couches antiferromagnétiques polycristallines, telles que mentionnées ci-avant, une mozaïcité qui se traduit par une distribution des axes [111] autour de l'axe z perpendiculaire au plan des couches, comme montrée sur la figure 1 qui représente de manière schématique une vue en coupe de l'interface entre une couche ferromagnétique 100 et une couche antiferromagnétique 200 granulaire composée d'une pluralité de grains (ici deux grains 200A et 200B sont représentés séparés par un joint de grain 300). A l'intérieur de chaque grain antiferromagnétique où la croissance est cohérente, les directions d'aimantation de la couche antiferromagnétique 200 forment donc un réseau complètement compensé orienté en moyenne parallèlement aux interfaces 400A et 400B entre la couche ferromagnétique 100 et la couche antiferromagnétique 200, mais distribués sur l'ensemble de la couche à cause des distributions des axes de croissance [111]. Ainsi, le couplage d'échange entre la couche ferromagnétique 100 et la couche antiferromagnétique 200 se fait essentiellement via les moments magnétiques (désignés indifféremment par la suite par vecteurs d'aimantation ou aimantations) non-compensés à l'interface, que l'on trouve aux joints de grains par exemple, ou au niveau des marches atomiques (cf. la marche atomique 500 entre les interfaces 400A et 400B) composant la rugosité interfaciale, puisque partout ailleurs (où la croissance de la première couche antiferromagnétique est cohérente), les moments interfaciaux antiferromagnétiques ont une résultante nulle et induisent peu, voire aucun couplage en moyenne avec la couche ferromagnétique 100.

En outre les moments antiferromagnétiques s'orientent préférentiellement selon certains axes faciles, cette anisotropie étant caractérisée par la constante d'anisotropie notée K_{AF} de la couche antiferromagnétique exprimée en erg/cm³.

Si on considère un seul grain antiferromagnétique ayant une géométrie cylindrique dont l'épaisseur est t_{AF} et la surface est S, afin d'observer un décalage du cycle d'hystérésis de la couche ferromagnétique en contact avec ce grain, il faut que K_{AF} ×S × t_{AF} > J₀ × S (1) où J₀ représente l'énergie d'interaction à l'interface entre la couche ferromagnétique et la couche antiferromagnétique exprimée en erg/cm². Cette inégalité (1) signifie que les moments antiferromagnétiques du grain ne doivent pas suivre les moments ferromagnétiques lors de la rotation de ceux-ci pour contribuer à l'anisotropie d'échange. Dès lors, dans une optique de miniaturisation susceptible d'induire une réduction des épaisseurs des dispositifs, on constate que l'effet du couplage n'est plus observé en-dessous d'une épaisseur critique. On sait de plus que la température de blocage des couches antiferromagnétiques diminue avec leur épaisseur, et qu'il faut atteindre cette température de blocage pour modifier la direction d'aimantation de la couche de stockage ferromagnétique (J. Appl. Phys. 83, 7216 (1998)). Cette diminution de la température de blocage (permettant des économies d'énergie lors des phases d'écriture) est ainsi limitée par l'existence de cette épaisseur critique au-dessous de laquelle l'effet de couplage n'est plus observé. Le fait de diminuer les épaisseurs de matériau antiferromagnétique dont le coût est important permet par ailleurs de réaliser des économies de fabrication.

Par ailleurs, dans une couche antiferromagnétique polycristalline granulaire, la taille des grains est largement distribuée. A titre purement illustratif, la figure 2 représente schématiquement une pluralité de grains de taille différente dans une structure comportant une couche antiferromagnétique AF et une couche ferromagnétique F. Sur cette figure, trois grains présentant des surfaces décroissantes de S1 à S3 sont illustrés. Conformément à l'inégalité (1) présentée au paragraphe précédent, on considère que seuls les grains les plus gros contribuent au champ d'échange. On sait que l'énergie d'interaction est dépendant de la surface des grains : plus cette surface est grande, moins l'énergie d'interaction est élevée, et réciproquement (J. Appl. Phys. 83, 6888 (1998)). Ainsi, dans le cas de la figure 2, les énergies d'échange J1 à J3 correspondant aux surfaces S1 à S3 sont de moins en moins élevées de sorte que l'effet de l'anisotropie d'échange des grains les plus petits est moins important.

Lorsque l'on diminue la taille des dispositifs à écriture assistée thermiquement de l'art antérieur, la stabilité de la couche antiferromagnétique diminue, tout comme le piégeage de la couche de stockage par la couche antiferromagnétique. En effet, la couche antiferromagnétique présente une structure granulaire polycristalline et les grains constituant la couche sont faiblement couplés magnétiquement entre eux. Or lorsque l'on diminue la taille du dispositif magnétique, on augmente la proportion de grains de la couche antiferromagnétique qui sont situés à la périphérie de la couche antiferromagnétique. De plus, ces grains en périphérie sont en partie rognés par le processus de gravure, ce qui a pour effet de rendre leur aimantation moins stable. On peut même les qualifier de magnétiquement instables lorsque la partie rognée dépasse un certain pourcentage de la surface initiale du grain. À mesure que la taille du dispositif diminue, la distribution de taille des grains constituant la couche antiferromagnétique tend à s'élargir. Il en résulte des fluctuations de propriétés de piégeage très importantes d'un dispositif à l'autre, et dans l'exemple des mémoires magnétiques d'un point mémoire à l'autre. Ainsi, lorsqu'on grave les dispositifs de l'art antérieur de faibles dimensions, le volume de ces grains périphériques diminue, ce qui entraîne une diminution de la cohérence magnétique de la couche antiferromagnétique liée notamment à la présence de petits grains. Cette diminution de la cohérence magnétique de la couche antiferromagnétique entraîne une diminution plus ou moins forte de la qualité de piégeage de la couche de stockage par la couche antiferromagnétique et une augmentation de la dispersion des propriétés de piégeage d'un point à l'autre.

L'invention vise à remédier aux inconvénients de l'état de la technique en proposant un dispositif magnétique à couplage d'échange augmenté pour une épaisseur de couche antiferromagnétique donnée, ledit dispositif permettant de diminuer l'épaisseur critique à partir de laquelle l'anisotropie d'échange est observée et entraînant des économies tant en termes de fabrication qu'en termes de consommation d'énergie lors de la phase d'écriture de l'aimantation de la couche ferromagnétique via l'obtention d'une température de blocage réduite.

Pour ce faire, l'invention propose un dispositif magnétique comportant :
- une couche magnétique, dite couche libre, présentant une direction d'aimantation variable ;
- une première couche antiferromagnétique au contact de ladite couche libre, ladite première couche antiferromagnétique étant apte à piéger la direction d'aimantation de ladite couche libre ;

le dispositif magnétique étant **caractérisé en ce qu'**il comporte en outre une couche réalisée dans un matériau ferromagnétique, dite couche de stabilisation, ladite couche de stabilisation étant au contact de ladite première couche antiferromagnétique par sa face opposée à ladite couche libre, les directions d'aimantation desdites couches libre et de stabilisation étant sensiblement perpendiculaires, une première couche parmi lesdites couches libre et de stabilisation présentant une aimantation dont la direction est orientée dans le plan de ladite première couche tandis que la deuxième des deux couches parmi lesdites couches libre et de stabilisation présente une aimantation dont la direction est orientée hors du plan de ladite deuxième couche.

Dans le cas de croissance dite colonnaire (caractéristique des empilements de couches magnétiques dont le dépôt est souvent réalisé par pulvérisation cathodique), les grains des différentes couches s'alignent de bas en haut. Dès lors, on entend par directions d'aimantation sensiblement perpendiculaires des aimantations perpendiculaires entre chacun des deux grains alignés appartenant respectivement à la couche de stabilisation et à la couche libre (i.e. situés l'un au-dessus de l'autre ou au-dessous de l'autre) et séparés l'un de l'autre par un grain de la couche antiferromagnétique.

Selon l'invention, on ajoute une couche de stabilisation en matériau ferromagnétique au contact de la couche antiferromagnétique de piégeage du côté opposé à celui de la couche ferromagnétique libre (typiquement la couche de stockage dans le cas d'une mémoire MRAM). La couche de stabilisation possède une anisotropie magnétique uniaxiale de sorte que son aimantation reste orthogonale à l'aimantation de la couche libre quelle que soit l'étape d'utilisation du dispositif (i.e. durant tous les processus d'écriture et de lecture). La couche libre et la couche de stabilisation exercent des interactions réciproques, propagées de proche en proche par le réseau antiferromagnétique : ces interactions sont d'autant plus importantes que l'épaisseur de la couche antiferromagnétique est faible (typiquement inférieure à 5nm). Dans cette situation, la couche de stabilisation exerce à la première interface avec la couche antiferromagnétique une interaction d'échange qui a pour effet un tilt des directions d'aimantation de la couche antiferromagnétique par rapport à leurs axes d'anisotropie. On entend par « tilt » une désorientation des moments magnétiques de leur axe d'anisotropie ou de leur position initiale. Dans l'épaisseur de la couche antiferromagnétique, ce tilt se propage dans le réseau via les interactions d'échanges jusqu'à la couche libre. À l'interface avec la couche libre, le tilt des directions d'aimantation de la couche antiferromagnétique induit permet de réduire, d'une valeur ΔJ₀ positive, l'énergie d'interaction J₀ à l'interface entre la couche libre et la couche antiferromagnétique. Cet effet est d'autant plus important que l'épaisseur de la couche antiferromagnétique est suffisamment faible pour que les directions d'aimantation de la couche antiferromagnétique ne relaxent pas vers leurs axes d'anisotropie : en d'autres termes, il conviendra avantageusement de choisir l'épaisseur de la couche antiferromagnétique de sorte que l'effet d'inclinaison des directions d'aimantation par rapport à l'axe d'anisotropie magnétique de la couche antiferromagnétique provoquée par la couche de stabilisation se propage jusqu'à l'interface de la couche antiferromagnétique avec la couche libre.

Les couches antiferromagnétiques de piégeage sont particulièrement utilisées pour piéger l'aimantation des couches libres ayant une aimantation dans le plan de la couche. Dans ce cas, la couche de stabilisation possède une direction d'aimantation hors du plan. Ainsi l'ajout d'une couche de stabilisation à anisotropie orthogonale à la couche libre permet de réduire l'interaction d'échange avec la couche antiferromagnétique de ΔJ₀. Il est important de noter que le raisonnement développé dans la présente invention convient aussi à des matériaux antiferromagnétiques à moments magnétiques non-compensés selon les plans de croissance de la couche antiferromagnétique. Une diminution de J₀ permet de réduire l'épaisseur critique à partir de laquelle on observe un décalage du cycle d'hystérésis de la couche libre ferromagnétique. La diminution de l'épaisseur critique à partir de laquelle apparaît un décalage du cycle d'hystérésis est indirectement un avantage pour l'écriture de la couche libre. En effet, on sait que la température de blocage des couches antiferromagnétiques diminue avec leur épaisseur, et qu'il faut atteindre cette température de blocage pour écrire la couche libre (J. Appl. Phys. 83, 7216 (1998)). La couche de stabilisation dans le cadre de ce mode de réalisation permet donc l'utilisation d'une couche antiferromagnétique plus fine, inscriptible à des températures moindres, entraînant par voie de conséquence des économies d'énergie lors des phases d'écriture.

La couche de stabilisation permet en outre d'augmenter la cohésion magnétique de la couche antiferromagnétique en augmentant le couplage effectif entre les grains constitutifs de la couche antiferromagnétique. La présence de cette couche de stabilisation en matériau ferromagnétique permet de renforcer le couplage de grains à grains à l'intérieur de la couche antiferromagnétique. En effet, lorsque la couche en matériau antiferromagnétique est seule, les grains qui la constituent sont très faiblement couplés entre eux. Au contraire, dans une couche en matériau ferromagnétique, les grains sont très fortement couplés entre eux. Lorsque l'on met en contact une couche ferromagnétique et une couche antiferromagnétique, l'aimantation des grains de la couche ferromagnétique a tendance à s'aligner avec le dernier plan de spins interfaciaux des grains de la couche en matériau antiferromagnétique. Il en résulte que chaque grain de la couche de stabilisation ferromagnétique est fortement couplé magnétiquement avec le grain de la couche antiferromagnétique avec lequel il est en contact. En outre, les grains de la couche de stabilisation en matériau ferromagnétique sont très fortement couplés entre eux, de sorte que les grains de la première couche antiferromagnétique deviennent également couplés entre eux, par l'intermédiaire des grains de la couche ferromagnétique. La couche de stabilisation permet donc d'augmenter la cohésion magnétique de la couche antiferromagnétique en induisant de façon indirecte un couplage entre grains à l'intérieur de la couche antiferromagnétique. Ainsi dans un dispositif de dimension latérale fortement submicronique, les grains situés à la périphérie du dispositif qui étaient initialement instables, se trouvent stabilisés par ce couplage indirect intergrains. Il en résulte que cette couche de stabilisation permet d'augmenter le couplage d'échange entre la couche antiferromagnétique et la couche de stockage. Ainsi hors événement d'écriture, c'est-à-dire tant que la couche antiferromagnétique n'est pas chauffée au dessus de sa température de blocage, le piégeage de la couche libre par la couche antiferromagnétique adjacente reste efficace même pour des dispositifs de dimension latérale fortement submicronique.

Le dispositif magnétique selon l'invention peut également présenter une ou plusieurs des caractéristiques ci-dessous, considérées individuellement ou selon toutes les combinaisons techniquement possibles.
- ladite couche de stabilisation présente une direction d'aimantation orientée hors du plan de ladite couche de stabilisation et ladite couche libre présente une direction d'aimantation dans le plan de ladite couche libre ;
- ladite couche de stabilisation est réalisée suivant l'un des agencements ou matériaux suivants :
   o une multicouche de période (Pt/Co), (Pd/Co), (Co/Ni) ou (Co/Pt/Cr/X), X étant du Ta ou du P ;
   o un alliage ordonné de FePt ou de FePd ;
   o un alliage de CoPt ou de CoPd ;
   o un alliage terre-rare/métal de transition ;
- l'épaisseur de ladite première couche antiferromagnétique est comprise entre 3 et 5 nm ;
- ladite couche libre comporte au moins un empilement formé par:
   o une couche de transition constituée d'un matériau ferromagnétique présentant une structure cristallographie cubique face centrée au contact de la première couche antiferromagnétique ;
   o une couche amorphe ou quasi-amorphe au contact de ladite couche de transition ;
   o une couche ferromagnétique ;
- ladite couche libre est constituée d'un empilement tricouche antiferromagnétique synthétique comportant une première et une deuxième couches magnétiques séparées par une couche conductrice non magnétique ;
- le dispositif selon l'invention présente une anisotropie de forme dans son plan ;
- le dispositif selon l'invention est un dispositif magnétique à écriture assistée thermiquement comportant :
   o une couche magnétique dite « couche de référence », ladite couche libre étant une couche de stockage ;
   o un espaceur situé entre ladite couche de référence et ladite couche de stockage ;
- ladite couche de référence présente une direction d'aimantation piégée par une deuxième couche antiferromagnétique disposée au contact de la couche de référence ;
- la couche de référence présente une direction d'aimantation variable.

L'invention concerne également une mémoire magnétique à écriture assistée thermiquement dont chaque point mémoire comporte un dispositif magnétique selon l'invention.

D'autres caractéristiques et avantages de l'invention ressortiront à la lecture de la description qui suit, en référence aux figures annexées :
- la figure 1 représente de manière schématique une vue en coupe de l'interface entre une couche ferromagnétique et une couche antiferromagnétique granulaire selon l'état de la technique ;
- la figure 2 représente schématiquement une pluralité de grains de taille différente dans une structure comportant une couche antiferromagnétique et une couche ferromagnétique selon l'état de la technique ;
- la figure 3 représente une vue en coupe d'un dispositif magnétique selon un premier mode de réalisation de l'invention ;
- la figure 4 représente une vue de dessus du dispositif magnétique de la figure 3 ;
- la figure 5 représente une vue en coupe schématique de l'interface entre la première couche antiferromagnétique du dispositif de la figure 3 et la couche de stabilisation d'une part et la couche de stockage d'autre part ;
- la figure 6 illustre les variations du champ d'échange avec ou sans la couche de stabilisation du dispositif selon l'invention ;
- la figure 7 représente une vue en coupe d'un dispositif magnétique selon un second mode de réalisation de l'invention ;
- la figure 8 représente une vue en coupe du dispositif de la figure 7 lors de l'écriture d'une information dans la couche de stockage.

Pour plus de clarté, les éléments identiques ou similaires sont repérés par des signes de référence identiques sur l'ensemble des figures.

Sur l'ensemble des figures, les flèches qui portent la référence « D » représentent la direction d'aimantation de la couche sur laquelle elles sont situées. Les flèches notées « I » représentent des courants d'électrons.

Les figures 1 et 2 ont déjà été décrites en référence à l'état de la technique.

Les figures 3 et 4 représentent un dispositif magnétique 24 selon un mode de réalisation de l'invention. Ce dispositif magnétique 24 comporte une couche tampon 1 qui sert de base à la croissance des autres couches du dispositif magnétique. Cette couche tampon 1 est de préférence réalisée dans un matériau non-magnétique. Elle peut par exemple être réalisée dans un alliage nickel-fer-chrome contenant au moins 20% de Cr, ou en nitrure de cuivre ou avoir une structure de multicouche constituée d'une alternance de couches de cuivre, et de couches de tantale. Bien entendu, ces matériaux ne sont donnés qu'à titre illustratif, sans restreindre l'invention.

Le dispositif magnétique 24 comporte également une couche de couverture 8 qui protège l'empilement de couches du dispositif magnétique de l'oxydation ou permet le cas échéant d'assurer la connexion électrique de l'empilement avec l'électrode supérieure de l'empilement. Cette couche de couverture 8 peut par exemple être constituée de tantale, de nitrure de cuivre ou avoir une structure de multicouche constituée d'une alternance de couches de cuivre et de couches de tantale.

Entre la couche tampon 1 et la couche de couverture 8, le dispositif magnétique comporte ensuite une deuxième couche antiferromagnétique 2 qui est disposée contre la couche tampon 1. Cette deuxième couche antiferromagnétique 2 peut être par exemple en PtMn d'épaisseur comprise entre 12 et 30 nm ou en NiMn d'épaisseur entre 20nm et 50nm. La deuxième couche antiferromagnétique 2 est de préférence réalisée dans un matériau antiferromagnétique qui présente une température de Néel élevée, typiquement supérieure ou égale à 350°C. Les matériaux cités ci-dessus pour la couche antiferromagnétique 2 ne sont donnés qu'à titre illustratif et d'autres matériaux pourraient être utilisés sans sortir du cadre de l'invention.

Le dispositif magnétique comporte ensuite une couche de référence 3 au contact de la deuxième couche antiferromagnétique 2. La couche de référence 3 peut être une monocouche, ou alors elle peut être constituée d'un empilement de couches, et notamment elle peut être constituée d'un empilement tricouche antiferromagnétique synthétique comme représenté sur la figure 3. L'empilement tricouche antiferromagnétique synthétique représenté sur la figure 3 est constitué de deux couches magnétiques 9 et 11 séparées par une couche conductrice non magnétique 10 apte à induire un alignement antiparallèle entre les aimantations des couches magnétiques adjacentes. La couche magnétique 9 peut par exemple être constituée d'un alliage cobalt-fer, tandis que la couche magnétique 11 peut être constituée d'un alliage cobalt-fer-bore, ou inversement. On peut également réaliser les deux couches magnétiques 9 et 11 dans le même alliage magnétique. Chaque couche magnétique 9 et 11 présente de préférence une épaisseur comprise entre 1 et 4 nm. Les deux couches magnétiques 9 et 11 présentent de préférence des épaisseurs voisines, de façon à ce que le champ rayonné par l'ensemble des deux couches magnétiques 9 et 11 au niveau de la couche de stockage 5 soit le plus faible possible. La couche conductrice non magnétique 10 peut par exemple être réalisée en ruthénium d'épaisseur entre 0.5 nm et 0.9nm, épaisseurs pour lesquelles il est connu que le ruthénium induit un couplage antiparallèle entre aimantations des couches magnétiques adjacentes. Les deux couches magnétiques 9 et 11 sont couplées antiparallèlement à travers la couche conductrice non magnétique 10. La direction d'aimantation des deux couches magnétiques 9 et 11 est figée par la deuxième couche antiferromagnétique 2, tant que le dispositif magnétique est à une température inférieure à la température de Néel du matériau antiferromagnétique qui constitue la deuxième couche antiferromagnétique 2. Les matériaux constitutifs de la couche de référence sont bien connus de l'homme du métier et ne sont donnés ici qu'à titre indicatif, sans pour autant restreindre l'invention.

La couche de référence 3 présente une direction d'aimantation dans le plan de la couche de référence.

Le dispositif magnétique comporte ensuite une couche libre de stockage 5 séparée de la couche de référence 3 par un espaceur 4. L'espaceur 4 peut être une barrière tunnel sélectionnée dans un groupe comprenant les oxydes d'aluminium AiOₓ, de titane TiOₓ et l'oxyde de magnésium MgO. Alternativement, l'espaceur 4 peut être constitué d'un semiconducteur. Ainsi, l'espaceur peut être constitué de silicium, de germanium ou de GaAs. On peut également réaliser l'espaceur 4 dans une couche métal/oxyde hétérogène comme une couche à chemins de courant confiné constituée d'une barrière isolante par exemple en Alumine d'épaisseur 2 nm percée de canaux conducteurs qui sont par exemple en cuivre de diamètre nanométrique, typiquement entre 1 et 4nm. L'espaceur 4 présente de préférence une épaisseur comprise entre 0.6nm et 5 nm.

La couche de stockage 5 est une couche magnétique libre qui présente une direction d'aimantation variable dans le plan de la couche libre. Cette couche de stockage 5 peut être une monocouche magnétique ou un empilement de couches. La couche de stockage 5 peut par exemple être constituée d'un empilement de couches comportant :
- une couche de transition constituée d'un matériau ferromagnétique présentant une structure cristallographie cubique face centrée au contact de la première couche antiferromagnétique ;
- une couche amorphe ou quasi-amorphe au contact de la couche de transition ;
- une couche ferromagnétique de stockage de structure cristallographique cubique centrée.

Ce type de couche de stockage est particulièrement intéressant dans le cas où l'espaceur 4 est une barrière tunnel à base de MgO dont la structure cristallographique est cubique centrée.

La couche de stockage 5 peut également être constituée d'un empilement tricouche antiferromagnétique synthétique comportant une première et une deuxième couches magnétiques séparées par une couche conductrice non magnétique.

Dans l'exemple de la figure 3, la couche de stockage 5 est constituée d'une monocouche. Cette monocouche peut par exemple être constituée de cobalt ou d'un alliage cobalt-fer-bore. La couche de stockage présente de préférence une épaisseur comprise entre 1 et 7 nm.

La couche de stockage 5 présente une direction d'aimantation dans le plan de la couche de stockage, cette direction étant variable et pouvant être parallèle ou antiparallèle à la direction d'aimantation de la couche de référence 3.

Bien entendu les caractéristiques de la couche de stockage ne sont données ici qu'à titre indicatif, et l'homme du métier saurait adapter l'invention à d'autres types de couches de stockage.

Le dispositif magnétique comporte ensuite, au contact de la couche de stockage 5, une première couche antiferromagnétique synthétique 6 qui permet de piéger la direction d'aimantation de la couche de stockage 5 lors de la lecture, et qui permet la libération de la direction d'aimantation de la couche de stockage 5 lors de l'écriture. La première couche antiferromagnétique 6 peut par exemple être en IrMn (par exemple un alliage Ir₂₀Mn₈₀) d'épaisseur comprise entre 3 et 5 nm.

Le dispositif magnétique comporte en outre, au contact de la première couche antiferromagnétique 6, une couche de stabilisation 7 réalisée dans un matériau ferromagnétique. Cette couche de stabilisation 7 possède une forte anisotropie uniaxiale hors du plan de la couche de stabilisation 7 et orthogonale à la direction d'aimantation de la couche de stockage 5. La couche de stabilisation 7 peut par exemple être réalisée sous la forme d'une multicouche du type platine/cobalt (une couche de platine et une couche de cobalt superposées) de forme générale (Pt/Co)m où m correspond au nombre de répétitions des motifs Pt/Co, par exemple (Pt_{1.8mm}/Co_{0.6mm})₃.

D'autres matériaux peuvent être utilisés pour la couche de stabilisation. Il peut s'agir par exemple d'alliage CoPtCr ou d'alliage CoPtCrX, X étant du Ta ou du P. On peut également utiliser des multicouches de cobalt/palladium de forme générale (Co/Pd)n ou cobalt/nickel de forme générale (Co/Ni)p, n et p correspondant respectivement aux nombres de répétitions des motifs Co/Pd et Co/Ni. On peut également utiliser tout type de matériau ferromagnétique à forte anisotropie perpendiculaire au plan, par exemple des alliages tels que CoPt ou CoPd, des alliages chimiquement ordonnés tels que FePt ou FePd ou certains alliages terre-rare/métaux de transition comme TbCo qui présentent aussi des anisotropies hors du plan.

Le dispositif magnétique 24 présente de préférence une section elliptique, comme on peut le voir plus précisément sur la figure 4, ou tout au moins une anisotropie de forme dans son plan.

Comme nous allons le voir dans ce qui suit, la couche de stabilisation 7 permet la diminution de l'épaisseur critique de la couche antiferromagnétique 6 à partir de laquelle apparaît un décalage du cycle d'hystérésis de la couche libre 5.

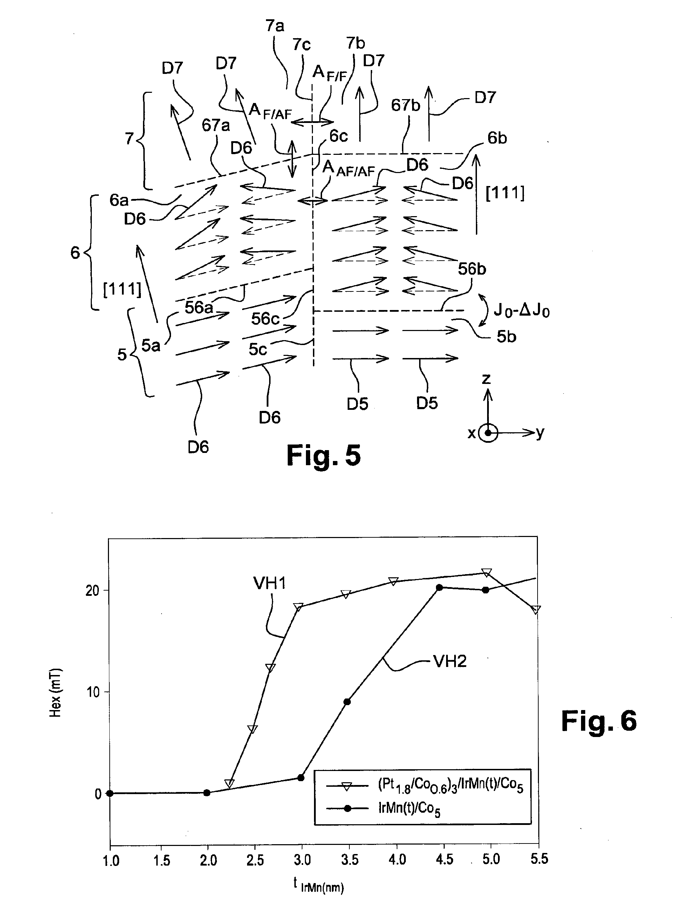

Ce phénomène va être expliqué plus en détail en référence à la figure 5 qui représente schématiquement, au niveau microscopique, la couche de stockage 5, la première couche antiferromagnétique 6 et la couche de stabilisation 7. Chacune de ces couches est constituée de grains (ici deux grains par couches sont représentés), respectivement 5a et 5b, 6a et 6b et 7a et 7b. Chaque grain 5a, 5b, 6a, 6b, 7a et 7b est un domaine monocristallin qui présente sensiblement la même orientation cristallographique.

Dans le cas de croissance dite colonnaire (caractéristique des empilements de couches magnétiques selon l'invention dont le dépôt est souvent réalisé par pulvérisation cathodique), les grains des différentes couches s'alignent de bas en haut : ainsi, les grains 5a, 6a et 7a sont alignés de bas en haut ; de même, les grains 5b, 6b et 7b sont alignés de bas en haut.

Au sein d'une même couche, par exemple au sein de la première couche antiferromagnétique 6, deux grains adjacents 6a et 6b, sont séparés par un joint de grain 6c. Il en va de même pour les joints de grain 5c et 7c séparant respectivement les joints 5a et 5b et les joints 7a et 7b. Les joints de grain 5c, 6c et 7c sont donc des zones dans lesquelles on passe d'une orientation cristallographique à une autre orientation cristallographique.

La croissance des couches 5, 6 et 7 se fait généralement selon l'axe [111].

Au sein de chacun des grains 5a et 5b de la couche libre 5, les directions D5 d'aimantation sont toutes parallèles entre elles, dans le même sens et dans le plan de la couche libre 5.

Au sein de chacun des grains 7a et 7b de la couche de stabilisation 7, les directions D7 d'aimantation sont toutes parallèles entre elles, dans le même sens, hors du plan de la couche de stabilisation 7. En outre, les aimantations D7 du grain 7a sont perpendiculaires aux aimantations D5 du grain 5a. De même, les aimantations D7 du grain 7b sont perpendiculaires aux aimantations D5 du grain 5b. De façon plus générale, les aimantations sont perpendiculaires entre chacun des deux grains alignés appartenant respectivement à la couche de stabilisation 7 et à la couche libre 5 et séparés l'un de l'autre par un grain de la couche antiferromagnétique 6.

Comme évoqué en référence à la figure 1, en l'absence de couche de stabilisation, les aimantations (représentées en pointillés) de la couche antiferromagnétique 6 s'orienteraient préférentiellement selon un axe facile d'anisotropie perpendiculaire à l'axe [111], cette anisotropie étant caractérisée par une constante d'anisotropie notée K_{AF}.

Lorsque l'épaisseur de la couche antiferromagnétique 6 est suffisamment faible (typiquement inférieure à 5nm), la couche de stockage (couche libre) 5 et la couche de stabilisation 7 exercent des interactions réciproques, propagées de proche en proche par le réseau antiferromagnétique. Dans cette situation, la couche de stabilisation 7 exerce à la première interface (interfaces 67a et 67b respectivement entre les grains 7a et 6a et les grains 7b et 6b) avec la couche antiferromagnétique 6 une interaction d'échange qui a pour effet un tilt des moments antiferromagnétiques par rapport à leurs axes d'anisotropie. Ce tilt se manifeste par une inclinaison des directions d'aimantations D6 de la couche antiferromagnétique par rapport aux axes faciles d'anisotropie en pointillés. Dans l'épaisseur de la couche antiferromagnétique 6, ce tilt se propage dans le réseau via les interactions d'échanges jusqu'à la couche de stockage 5. À l'interface de la couche antiferromagnétique 6 (interfaces 56a et 56b respectivement entre les grains 5a et 6a et les grains 5b et 6b et marche atomique 56c entre les interfaces 56a et 56b) avec la couche de stockage 5, le tilt des moments antiferromagnétiques induit permet de réduire d'une valeur ΔJ₀ positive, l'énergie d'interaction J₀ (on parlera également de densité surfacique d'énergie d'échange). Cet effet est d'autant plus efficace que l'épaisseur de la couche antiferromagnétique 6 est suffisamment faible pour que les moments antiferromagnétiques ne relaxent pas vers leurs axes d'anisotropie. Ainsi l'ajout d'une couche de stabilisation 7 à aimantation hors de son plan et à anisotropie orthogonale à la couche libre 5 permet de réduire l'interaction d'échange avec la couche antiferromagnétique de ΔJ₀. Il est important de noter que le raisonnement développé dans la présente invention convient aussi à des matériaux antiferromagnétiques non-compensés (i.e. cas d'une interface entre la couche libre et la couche antiferromagnétique présentant une aimantation nette non nulle) selon les plans de croissance de la couche antiferromagnétique.

En appliquant l'inégalité (1) donnée en introduction, on comprend bien que l'épaisseur t_{AF} de la couche antiferromagnétique peut être choisie plus fine qu'en l'absence de la couche de stabilisation 7 tout en continuant à observer un décalage du cycle d'hystérésis de la couche ferromagnétique libre 5, l'inégalité (1) devenant : K_{AF} ×S × t_{AF} > (J₀ -ΔJ₀)× S si on considère un seul grain antiferromagnétique ayant une géométrie cylindrique dont l'épaisseur est t_{AF} et la surface est S. Cette inégalité signifie que les moments antiferromagnétiques du grain ne doivent pas suivre les moments ferromagnétiques lors de la rotation de ceux-ci pour contribuer à l'anisotropie d'échange. Dans ce modèle simple, on voit qu'une diminution de J₀ permet de réduire l'épaisseur critique t_{AFCri} à partir de laquelle l'inégalité est vérifiée. En présence d'un décalage du cycle d'hystérésis, la couche libre se comporte comme si il y avait un champ effectif interne additionnel et unidirectionnel : le champ d'échange (« Exchange bias field » en anglais) Hₑₓ.

La figure 6 représente les variations VH1 et VH2 des champs d'échange Hₑₓ mesurés sur la couche libre avec (courbe VH1) et sans (courbe VH2) couche de stabilisation en fonction de l'épaisseur de la couche antiferromagnétique. On remarque que l'ajout de la couche de stabilisation sur la deuxième interface de la couche antiferromagnétique permet de réduite notablement l'épaisseur critique à laquelle apparaît le couplage d'échange. Par exemple, pour une épaisseur antiferromagnétique de 3nm, le champ d'échange mesuré sur la couche de stockage sans couche de stabilisation est de 1.33mT, alors qu'il est de 18mT lorsque la couche de stabilisation est présente, soit amélioré d'un facteur dix. Dans le cadre de cette démonstration expérimentale, la couche de stockage était composée de Co de 5nm d'épaisseur à aimantation planaire, la couche de stabilisation était une multicouche (Pt_{1.8nm}/Co_{0.6nm})₃ qui possède une forte anisotropie uniaxiale perpendiculaire au plan, et donc à l'aimantation de la couche de stockage, et la couche antiferromagnétique était constitué d'un alliage Ir₂₀Mn₈₀ d'épaisseur variable. On observe par ailleurs la présence d'un champ d'échange Hₑₓ à partir d'une épaisseur critique de 2.25nm en présence de la couche de stabilisation alors que ce champ d'échange apparaît à partir d'une épaisseur critique de 3 nm en l'absence de couche de stabilisation.

La diminution de l'épaisseur critique à partir de laquelle apparaît un décalage du cycle d'hystérésis est indirectement un avantage pour l'écriture de la couche libre à aimantation variable. En effet, on sait que la température de blocage des couches antiferromagnétiques diminue avec leur épaisseur, et qu'il faut atteindre cette température de blocage pour écrire la couche de stockage (J. Appl. Phys. 83, 7216 (1998)). La couche de stabilisation dans le cadre de ce mode de réalisation permet donc d'utiliser une couche antiferromagnétique plus fine, inscriptible à des températures moindres, entraînant par voie de conséquence des économies d'énergie lors des phases d'écriture.

Comme nous l'avons vu en référence à la figure 2, seuls les grains les plus gros contribuent au champ d'échange. On sait que l'énergie d'interaction est dépendant de la surface des grains : plus cette surface est grande, moins l'énergie d'interaction est élevée, et réciproquement (J. Appl. Phys. 83, 6888 (1998)). En l'espèce, en diminuant l'énergie d'interaction via l'utilisation de la couche de stabilisation 7, les grains les plus petits de la couche antiferromagnétique se voient aussi être stabilisés.

La couche de stabilisation 7 permet par ailleurs de renforcer la cohérence magnétique de la première couche antiferromagnétique 6, et, elle permet d'augmenter le piégeage de la direction d'aimantation de la couche de stockage 5 par la première couche antiferromagnétique 6.

En l'absence de couche de stabilisation, deux grains adjacents de la première couche antiferromagnétique 6 sont très faiblement couplés magnétiquement, ce qui fait que la cohérence magnétique de la première couche antiferromagnétique 6 est faible. En d'autres termes, l'énergie de couplage A_{AF/AF} entre deux grains de la première couche antiferromagnétique en l'absence de la couche de stabilisation est très faible.

Dans ce document, on appelle « énergie de couplage » entre deux joints de grains l'énergie de couplage par unité de surface. Cette énergie s'exprime en erg/cm²_{.}

Au sein de la couche de stabilisation 7, qui est ferromagnétique, les grains sont très fortement couplés. Ainsi, l'énergie de couplage A_{F/F} entre deux grains adjacents de la couche de stabilisation est environ 10⁴ à 10⁵ fois plus forte que l'énergie de couplage A_{AF/AF} entre deux grains de la première couche antiferromagnétique en l'absence de la couche de stabilisation.

Ainsi, pour augmenter le couplage entre les grains de la première couche antiferromagnétique 6, l'invention propose d'ajouter une couche de stabilisation ferromagnétique 7 sur la première couche antiferromagnétique 6.

Comme on peut le voir schématiquement sur la figure 5, chaque grain de la couche de stabilisation, par exemple 7a, est magnétiquement couplé avec le grain 6a de la première couche antiferromagnétique 6 au dessus duquel il se trouve. Par conséquent, les grains de la première couche antiferromagnétique 6 sont couplés entre eux par l'intermédiaire du couplage interfacial entre les grains de la couche de stabilisation et la première couche antiferromagnétique et du couplage inter-grains entre les grains de la couche de stabilisation.

La présence de la couche de stabilisation ferromagnétique permet donc l'existence d'un couplage effectif entre les grains de la première couche antiferromagnétique. Ce couplage permet de faire en sorte que des grains de la première couche antiferromagnétique qui serait magnétiquement instables sans la couche de stabilisation, deviennent magnétiquement stables en présence de la couche de stabilisation du fait de l'apparition du couplage inter-grains induit par la couche de stabilisation. Ceci concerne particulièrement les grains en bordure du dispositif dont la taille a pu fortement diminuer pendant le processus de gravure du dispositif.

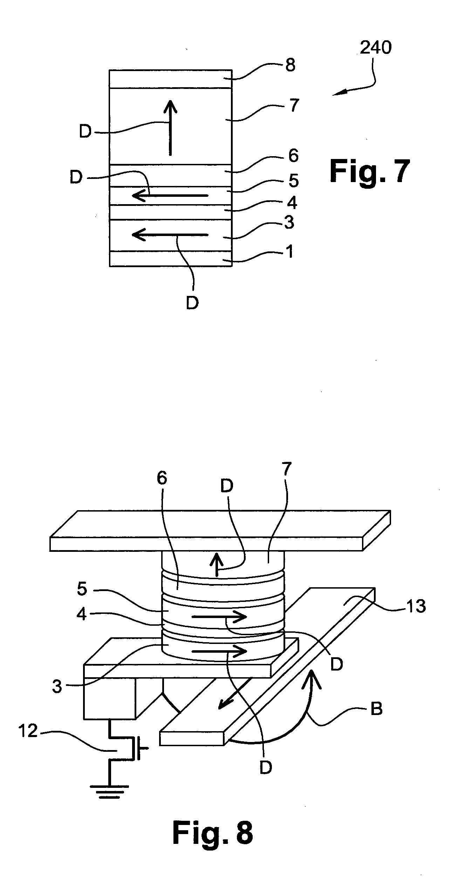

La figure 7 représente une vue en coupe d'un dispositif magnétique 240 selon un second mode de réalisation de l'invention

Le dispositif 240 est quasi identique au dispositif 24 de la figure 3, la seule différence résidant dans le fait que le dispositif 240 comporte une couche de référence 3 dont la direction d'aimantation n'est pas figée par une couche antiferromagnétique. La couche de référence 3 présente une direction d'aimantation variable. Cette couche de référence 3 peut être une monocouche ou une multicouche.

Le dispositif magnétique de la figure 7 comporte également une couche de stockage 5 dont la direction d'aimantation est variable. La couche de stockage 5 peut être une monocouche ou une multicouche.

La couche de référence 3 et la couche de stockage 5 sont séparées par un espaceur 4.

Le dispositif magnétique 240 comporte en outre, au contact de la première couche antiferromagnétique 6, une couche de stabilisation 7 réalisée dans un matériau ferromagnétique. Cette couche de stabilisation 7 possède une forte anisotropie uniaxiale hors du plan de la couche de stabilisation 7 et orthogonale à la direction d'aimantation de la couche de stockage 5. En outre, le dispositif magnétique peut également comporter une couche tampon 1 et une couche de couverture 8 de part et d'autre du dispositif.

La figure 8 représente une vue en coupe du dispositif de la figure 7 lors de l'écriture d'une information dans la couche de stockage

Pour permettre l'écriture d'une information dans la couche de stockage, le dispositif magnétique comporte un transistor 12 qui est conducteur en mode écriture. En outre, le dispositif magnétique comporte une ligne conductrice 13 située au dessous de l'empilement magnétique. Le premier conducteur 13 est agencé de façon à ce que, lorsqu'il est traversé par un courant électrique, il créé un champ magnétique qui est parallèle ou antiparallèle à la direction d'aimantation de la couche de stabilisation. A l'écriture, le transistor 12 est en mode passant de sorte qu'un courant peut circuler à travers l'empilement provoquant un échauffement de la couche de stockage et de la première couche antiferromagnétique par effet Joule. Cet échauffement atteint une température supérieure ou égale à la température de blocage de la première couche antiferromagnétique. Grâce à l'invention, cette température de blocage est inférieure à la température de blocage de cette même couche antiferromagnétique en l'absence de la couche de stabilisation 7.

Pour écrire une information dans la couche de stockage, on envoie un courant à travers le conducteur 13 et à travers l'empilement, le transistor 12 étant passant. L'empilement s'échauffe alors à une température supérieure à la température de blocage de la première couche antiferromagnétique 6, de sorte que la première couche antiferromagnétique 6 devient paramagnétique et que la direction d'aimantation de la couche de stockage 5 n'est plus piégée.

Simultanément, un champ magnétique B est créé par le premier conducteur 13. Ce champ magnétique n'a aucun impact sur la couche de stabilisation 7 qui présente une forte anisotropie perpendiculaire au plan de sa couche.

Le champ B permet de mettre l'aimantation de la couche de stockage dans la direction voulue.

Une fois que la direction d'aimantation de la couche de stockage 5 a été placée dans le sens voulu, on coupe le courant qui traverse l'empilement pour permettre à l'empilement de se refroidir en présence du champ magnétique puis on coupe le courant dans le conducteur 13 pour supprimer le champ appliqué. La première couche antiferromagnétique 6 étant redevenue antiferromagnétique, elle piège la direction d'aimantation de la couche de stockage 5 dans la direction dans laquelle elle se trouve.

Il est à noter que pendant cette écriture, la couche de référence commute aussi dans la direction du champ local créé par le conducteur 13 et partiellement rayonné par les autres couches magnétiques mais ceci n'a pas d'importance puisque l'aimantation de cette couche va ensuite être réorientée dans une direction prédéterminée au moment de la lecture.

Ensuite, pour lire l'information contenue dans la couche de stockage 5, on peut effectuer une lecture différentielle grâce à la couche de référence 3. Pour cela, on compare le niveau de résistance de la jonction tunnel formée par le dispositif magnétique pour deux orientations différentes de la direction d'aimantation de la couche de référence 3. Pour cela, on oriente, avec un premier pulse de champ magnétique produit par un premier pulse de courant dans le conducteur 13, la direction d'aimantation de la couche de référence 3 dans un premier sens prédéterminé. Cette orientation de la direction d'aimantation de la couche de référence 3 a lieu sans faire circuler de courant à travers l'empilement pour ne pas le chauffer et ainsi pour ne pas modifier la direction de l'aimantation de la couche de stockage 5. On mesure alors la résistance du dispositif magnétique à l'aide d'un courant de lecture plus faible, typiquement divisé par un facteur 2, que le courant de chauffage utilisé au moment de l'écriture. On applique ensuite un deuxième pulse de champ magnétique généré par un deuxième pulse de courant dans le conducteur 13 opposé au premier pulse, toujours sans chauffer, de façon à orienter la direction d'aimantation de la couche de référence 3 dans le sens opposé au premier sens prédéterminé. On mesure alors à nouveau la résistance du dispositif magnétique. Après chaque pulse de courant, on connaît la direction d'aimantation de la couche de référence 3, puisqu'on connaît la direction des pulses de champs magnétiques appliqués. Par conséquent, en comparant la résistance du dispositif magnétique après le premier pulse de courant et après le deuxième pulse de courant, on en déduit la direction d'aimantation de la couche de stockage 5, et donc l'information contenue dans la couche de stockage 5.

Comme illustré en figure 3, l'invention s'applique tout autant avec une couche de référence dont la direction d'aimantation est piégée.

Pour écrire une information dans la couche de stockage, on peut alors utiliser la couche de référence. Pour cela, on peut par exemple appliquer un champ magnétique extérieur au dispositif magnétique comme cela a été décrit en relation avec la figure 8. Mais il est aussi possible d'écrire en faisant circuler un courant d'électrons à travers les couches du dispositif magnétique, perpendiculairement aux couches, dans un sens ou l'autre c'est-à-dire de bas en haut ou de haut en bas suivant que l'on veut rendre l'aimantation de la couche de stockage parallèle ou antiparallèle à celle de la couche de référence. Ce courant a un double effet. Tout d'abord, indépendamment de son sens de direction, il provoque par effet Joule au niveau de la barrière tunnel un échauffement de la structure au dessus de la température de blocage de la couche antiferromagnétique. Cela a pour effet de libérer l'aimantation de la couche de stockage qui n'est plus piégée par interaction avec la couche antiferromagnétique. Par ailleurs, lorsque ce courant d'électrons traverse la couche de référence qui est magnétique, les spins des électrons vont se trouver polarisés en spin, de sorte que les électrons sortiront de cette couche de référence avec un spin polarisé. Lorsque ces électrons traversent la couche de stockage, ils vont subir des interactions d'échange avec les spins responsables de l'aimantation de la couche de stockage. Si la densité de courant est suffisamment forte, ceci va provoquer une réorientation de l'aimantation de cette couche et un alignement de l'aimantation de la couche de stockage par transfert du moment angulaire des électrons polarisés au moment magnétique de la couche de stockage. Ce phénomène est connu sous le nom de transfert de spin. Ainsi, si le courant d'électrons circule de la couche de référence vers la couche de stockage, le transfert de spin va favoriser l'orientation parallèle des aimantations des couches de stockage et de référence. Par contre, si le courant d'électrons circule de la couche de stockage vers la couche de référence, c'est l'alignement antiparallèle qui est favorisé. Dans ce mode d'écriture, le transfert de spin s'exerce avant tout sur l'aimantation de la couche de stockage.

En mode lecture, on envoie un courant d'électrons à travers les couches et on mesure la résistance du dispositif magnétique. Ce courant de lecture est d'intensité plus faible que le courant d'écriture (typiquement d'au moins 50%) pour ne pas risquer de perturber par transfert de spin l'orientation magnétique de la couche de stockage au moment de la lecture. On compare ensuite la résistance mesurée à une valeur de référence standard. Si la résistance mesurée est supérieure à cette valeur de référence standard, on en déduit la couche de stockage présente une direction d'aimantation antiparallèle à celle de la couche de référence. Si la résistance mesurée est inférieure à cette valeur de référence standard, on en déduite que les couches de stockage et de référence présentent des directions d'aimantations parallèles.

Naturellement, l'invention n'est pas limitée aux modes de réalisation décrits en référence aux figures et des variantes peuvent être envisagées sans sortir du cadre de l'invention. En particulier, les matériaux et les épaisseurs choisis pour réaliser les couches tampon, les couches de référence, les couches de stockage et les espaceurs ne sont donnés ici qu'à titre illustratif et d'autres matériaux ou épaisseurs pourraient être utilisés.

Même si les modes de réalisation décrits du dispositif selon l'invention sont plus spécifiquement destinés à être mis en oeuvre dans des mémoires magnétiques à écriture assistée thermiquement, il est entendu que le dispositif selon l'invention peut être mis en en oeuvre dans d'autres dispositifs magnétiques tels que des capteurs de champ magnétique ou des têtes de lecture pour support d'enregistrement magnétique dès lors que ces dispositifs nécessitent l'utilisation d'une couche antiferromagnétique de piégeage de l'aimantation d'une couche libre.

Dans l'ensemble des modes de réalisation décrits en référence aux figures, les couches magnétiques de stockage (couches libres) présentent une direction d'aimantation dans le plan, c'est-à-dire que l'aimantation de la couche magnétique libre est parallèle ou antiparallèle au plan dans lequel la couche libre se trouve tandis que les couches magnétiques de stabilisation présentent une aimantation hors du plan, c'est-à-dire que l'aimantation de la couche magnétique de stabilisation est perpendiculaire au plan dans lequel se trouvent la couche magnétique de stabilisation. Toutefois, on pourrait également réaliser le dispositif magnétique selon l'invention avec des aimantations hors du plan pour les couches libres et dans le plan pour les couches de stabilisation. Dans ce cas, la direction du champ magnétique permettant de retourner l'aimantation de la couche libre doit bien entendu être perpendiculaire au plan des couches.

## Revendications

1. Dispositif magnétique (24, 240) comportant :
- une couche magnétique (5), dite couche libre, présentant une direction d'aimantation variable ;
- une première couche antiferromagnétique (6) au contact de ladite couche libre (5), ladite première couche antiferromagnétique (6) étant apte à piéger la direction d'aimantation de ladite couche libre (5) ;
le dispositif magnétique (24, 240) étant **caractérisé en ce qu'**il comporte en outre une couche réalisée dans un matériau ferromagnétique (7), dite couche de stabilisation, ladite couche de stabilisation (7) étant au contact de ladite première couche antiferromagnétique (6) par sa face opposée à ladite couche libre (5), les, directions d'aimantation desdites couches libre (5) et de stabilisation (7) étant sensiblement perpendiculaires, une première couche (5) parmi lesdites couches libre (5) et de stabilisation (7) présentant une aimantation dont la direction est orientée dans le plan de ladite première couche (5) tandis que la deuxième (7) des deux couches parmi lesdites couches libre (5) et de stabilisation (7) présente une aimantation dont la direction est orientée hors du plan de ladite deuxième couche (7).

2. Dispositif magnétique (24, 240) selon la revendication précédente, **caractérisé en ce que** ladite couche de stabilisation (7) présente une direction d'aimantation orientée hors du plan de ladite couche de stabilisation (7) et ladite couche libre (5) présente une direction d'aimantation dans le plan de ladite couche libre (5).

3. Dispositif magnétique (24, 240) selon la revendication précédente **caractérisé en ce que** ladite couche de stabilisation (7) est réalisée suivant l'un des agencements ou matériaux suivants :
- une multicouche de période (Pt/Co), (Pd/Co), (Co/Ni) ou (Co/Pt/Cr/X), X étant du Ta ou du P ;
- un alliage ordonné de FePt ou de FePd ;
- un alliage de CoPt ou de CoPd ;
- un alliage terre-ràre/métal de transition.

4. Dispositif (24, 240) selon l'une des revendications précédentes **caractérisé en ce que** l'épaisseur de ladite première couche antiferromagnétique (6) est comprise entre 3 et 5 nm.

5. Dispositif magnétique selon l'une des revendications précédentes, **caractérisé en ce que** ladite couche libre comporte au moins un empilement formé par:
- une couche de transition constituée d'un matériau ferromagnétique présentant une structure cristallographie cubique face centrée au contact de la première couche antiferromagnétique ;
- une couche amorphe ou quasi-amorphe au contact de ladite couche de transition ;
- une couche ferromagnétique.

6. Dispositif magnétique selon l'une des revendications 1 à 4, **caractérisé en ce que** ladite couche libre est constituée d'un empilement tricouche antiferromagnétique synthétique comportant une première et une deuxième couches magnétiques séparées par une couche conductrice non magnétique.

7. Dispositif magnétique (24) selon l'une des revendications précédentes, **caractérisé en ce qu'**il présente une anisotropie de forme dans son plan.

8. Dispositif magnétique (24, 240) selon l'une des revendications précédentes **caractérisé en ce que** ledit dispositif (24, 240) est un dispositif magnétique à écriture assistée thermiquement comportant :
- une couche magnétique (3) dite « couche de référence », ladite couche libre (5) étant une couche de stockage ;
- un espaceur (4) situé entre ladite couche de référence (3) et ladite couche de stockage (5).

9. Dispositif magnétique (24) selon la revendication précédente **caractérisé en ce que** ladite couche de référence (3) présente une direction d'aimantation piégée par une deuxième couche antiferromagnétique (2) disposée au contact de la couche de référence (3).

10. Dispositif magnétique (240) selon la revendication 8 **caractérisé en ce que** la couche de référence (3) présente une direction d'aimantation variable.

11. Mémoire magnétique à écriture assistée thermiquement dont chaque point mémoire comporte un dispositif magnétique selon l'une des revendications 8 à 10.

## Patentansprüche

1. Magnetische Vorrichtung (24, 240), umfassend:
- eine als freie Schicht bezeichnete magnetische Schicht (5), welche eine variable Magnetisierungsrichtung aufweist;
- eine erste, mit der genannten freien Schicht (5) in Kontakt stehende antiferromagnetische Schicht (6), wobei die genannte erste antiferromagnetische Schicht (6) geeignet ist, die Magnetisierungsrichtung der genannten freien Schicht (5) einzufangen;
wobei die magnetische Vorrichtung (24, 240) **dadurch gekennzeichnet** ist, dass sie darüber hinaus eine aus einem ferromagnetischen Material (7) realisierte, als Stabilisierungsschicht bezeichnete Schicht umfasst, wobei die genannte Stabilisierungsschicht (7) mit der genannten ersten antiferromagnetischen Schicht (6) durch ihre der genannten freien Schicht (5) entgegengesetzte Seite in Kontakt ist, wobei die Magnetisierungsrichtungen der genannten freien Schicht (5) und der Stabilisierungsschicht (7) deutlich lotrecht sind, wobei eine erste Schicht (5) aus der genannten freien Schicht (5) und der Stabilisierungsschicht (7) eine Magnetisierung aufweist, deren Richtung in der Ebene der genannten ersten Schicht (5) ausgerichtet ist, während die zweite (7) der zwei Schichten aus der genannten freien Schicht (5) und der Stabilisierungsschicht (7) eine Magnetisierung aufweist, deren Richtung außerhalb der Ebene der genannten zweiten Schicht (7) ausgerichtet ist.

2. Magnetische Stapelung (24, 240) gemäß dem voranstehenden Anspruch, **dadurch gekennzeichnet, dass** die genannte Stabilisierungsschicht (7) eine außerhalb der Ebene der genannten Stabilisierungsschicht (7) ausgerichtete Magnetisierungsrichtung aufweist und die genannte freie Schicht (5) eine Magnetisierungsrichtung in der Ebene der genannten freien Schicht (5) aufweist.

3. Magnetische Vorrichtung (24, 240) gemäß dem voranstehenden Anspruch, **dadurch gekennzeichnet, dass** die genannte Stabilisierungsschicht (7) gemäß einer der folgenden Anordnungen oder Materialien realisiert ist:
- einer Perioden-Mehrfachschicht (Pt/Co), (Pd/Co), (Co/Ni) oder (Co/Pt/Cr/X), wobei X Ta oder P ist,
- einer geordneten Legierung aus FePt oder FePd;
- einer Legierung aus CoPt oder CoPd;
- einer Legierung seltene Erde / Übergangsmetall.

4. Vorrichtung (24, 240) gemäß einem der voranstehenden Ansprüche, **dadurch gekennzeichnet, dass** die Dicke der genannten ersten antiferromagnetischen Schicht (6) zwischen 3 und 5 nm inbegriffen ist.

5. Magnetische Vorrichtung gemäß einem der voranstehenden Ansprüche, **dadurch gekennzeichnet, dass** die genannte freie Schicht wenigstens eine Stapelung umfasst, geformt durch:
- eine aus einem ferromagnetischen Material gebildete Schicht, die eine kubische Kristallographie-Struktur aufweist, deren zentrierte Seite mit der ersten ferromagnetischen Schicht in Kontakt ist;
- eine amorphe oder quasi-amorphe Schicht in Kontakt mit der genannten Übergangsschicht;
- eine ferromagnetische Schicht.

6. Magnetische Vorrichtung gemäß Anspruch 1 bis 4, **dadurch gekennzeichnet, dass** die genannte freie Schicht aus einer dreischichtigen, antiferromagnetischen, synthetischen Stapelung gebildet ist, die eine erste und eine zweite magnetische, durch eine leitende, nicht magnetische Schicht getrennte Schicht umfasst.

7. Magnetische Vorrichtung (24) gemäß einem der voranstehenden Ansprüche, **dadurch gekennzeichnet, dass** sie in ihrer Ebene eine Form-Anisotropie aufweist.

8. Magnetische Vorrichtung (24, 240) gemäß einem der voranstehenden Ansprüche, **dadurch gekennzeichnet, dass** die genannte Vorrichtung (24, 240) eine magnetische Vorrichtung mit thermisch unterstütztem Schreiben ist, umfassend:
- eine als "Referenzschicht" bezeichnete magnetische Schicht (3), wobei die genannte freie Schicht (5) eine Abspeicherschicht ist;
- einen sich zwischen der genannten Referenzschicht (3) und der genannten Abspeicherschicht (5) befindenden Abstandshalter (4).

9. Magnetische Vorrichtung (24) gemäß dem voranstehenden Anspruch, **dadurch gekennzeichnet, dass** die genannte Referenzschicht (3) eine durch eine zweite antiferromagnetische Schicht (2) in Kontakt mit der Referenzschicht (3) angeordnete eingefangene Magnetisierungsrichtung aufweist.

10. Magnetische Vorrichtung (240) gemäß Anspruch 8, **dadurch gekennzeichnet, dass** die Referenzschicht (3) eine variable Magnetisierungsrichtung aufweist.

11. Magnetischer Speicher mit thermisch unterstütztem Schreiben, bei dem jeder Speicherpunkt eine magnetische Vorrichtung gemäß Anspruch 8 bis 10 umfasst.

## Claims

1. Magnetic device (24, 240) comprising:
- a magnetic layer (5) called the free layer, with a variable magnetisation direction;
- a first antiferromagnetic layer (6) in contact with said free layer (5), said first antiferromagnetic layer (6) being capable of pinning the magnetisation direction of said free layer (5);
the magnetic device (24, 240) being **characterised in that** it also comprises a layer made from a ferromagnetic material (7) called the stabilisation layer, said stabilisation layer (7) being in contact with said first antiferromagnetic layer (6) through its face opposite said free layer (5), the magnetisation directions of said free layer (5) and said stabilisation layer (7) being approximately perpendicular, a first layer (5) among said free layer (5) and said stabilisation layer (7) having a magnetisation in the direction oriented in the plane of said first layer (5) while the second layer (7) of said two layers among said free layer (5) and said stabilisation layer (7) has a magnetisation along a direction oriented out of the plane of said second layer (7).

2. Magnetic device (24, 240) according to the previous claim, **characterised in that** said stabilisation layer (7) has a magnetisation direction oriented out of the plane of said stabilisation layer (7) and said free layer (5) has a magnetisation direction in the plane of said free layer (5).

3. Magnetic device (24; 240) according to the previous claim, **characterised in that** said stabilisation layer (7) is made according to one of the following arrangements or materials:
- a period multilayer (Pt/Co); (Pd/Co), (Co/Ni) or (Co/Pt/Cr/X), where X is Ta or P;
- an ordered alloy of FePt or FePd;
- an alloy of CoPt or CoPd;
- a rare earth/transition metal alloy.

4. Device (24, 240) according to one of the previous claims, **characterised in that** the thickness of said first antiferromagnetic layer (6) is between 3 and 5 nm.

5. Magnetic device according to one of the previous claims, **characterised in that** said free layer comprises at least one stack formed by:
- a transition layer composed of a ferromagnetic material with a face centred cubic crystallographic structure in contact with the first antiferromagnetic layer;
- an amorphous or quasi-amorphous layer in contact with said transition layer;
- a ferromagnetic layer.

6. Magnetic device according to one of claims 1 to 4, **characterised in that** said free layer is composed of a three-layer synthetic antiferromagnetic stack comprising a first magnetic layer and a second magnetic layer separated by a non-magnetic conducting layer.

7. Magnetic device (24) according to one of the previous claims, **characterised in that** it has a shape anisotropy in its plane.

8. Magnetic device (24, 240) according to one of the previous claims, **characterised in that** said device (24, 240) is a thermally assisted magnetic write device comprising:
- a magnetic layer (3) called the "reference layer", said free layer (5) being a storage layer;
- a spacer (4) located between said reference layer (3) and said storage layer (5)

9. Magnetic device (24) according to the previous claim, **characterised in that** said reference layer (3) has a direction of magnetisation pinned by a second anteriferromagnetic layer (2) arranged in contact with the reference layer (3).

10. Magnetic device (240) according to claim 8, **characterised in that** the reference layer (3) has a variable magnetisation direction.

11. Thermally-assisted magnetic write memory in which each memory dot comprises a magnetic device according to one of claims 8 to 10.
